(19) Europäisches Patentamt

European Patent Office

Office européen des brevets

(11) Publication number: **0 312 137 B1**

## (12) EUROPEAN PATENT SPECIFICATION

(45) Date of publication of patent specification: **15.09.93** (51) Int. Cl.⁵: **H03H 17/04**

(21) Application number: **88202072.0**

(22) Date of filing: **23.06.86**

(60) Publication number of the earlier application in accordance with Art.76 EPC: **0 209 931**

(54) **Bandfilter.**

(30) Priority: **26.06.85 NL 8501834**

(43) Date of publication of application:
**19.04.89 Bulletin 89/16**

(45) Publication of the grant of the patent:
**15.09.93 Bulletin 93/37**

(84) Designated Contracting States:
**DE FR GB**

(56) References cited:
**EP-A- 0 090 464**

**PROCEEDINGS OF THE IEEE, vol. 66, no. 9, September 1978, pages 1082-1083, IEEE, New York, US; J. SZCZUPAK et al.: "On digital filter structures with low coefficient sensitivities"**

(73) Proprietor: **N.V. Philips' Gloeilampenfabrieken Groenewoudseweg 1 NL-5621 BA Eindhoven(NL)**

(72) Inventor: **Rijnsburger, Johan Martien c/o INT. OCTROOIBUREAU B.V. Prof. Holstlaan 6 NL-5656 AA Eindhoven(NL)**

(74) Representative: **van der Kruk, Willem Leonardus et al INTERNATIONAAL OCTROOIBUREAU B.V. Prof. Holstlaan 6 NL-5656 AA Eindhoven (NL)**

EP 0 312 137 B1

## Description

The invention relates to a digital band filter having an input coupled to a series arrangement of a first signal combination unit, a first delay means, a second signal combination unit and a second delay means, the outputs of the first and second delay means being coupled, via associated feedback paths, to an input of the first signal combination unit and an input of the second signal combination unit respectively, the output of the second delay means being also fed back to an input of the first signal combination unit.

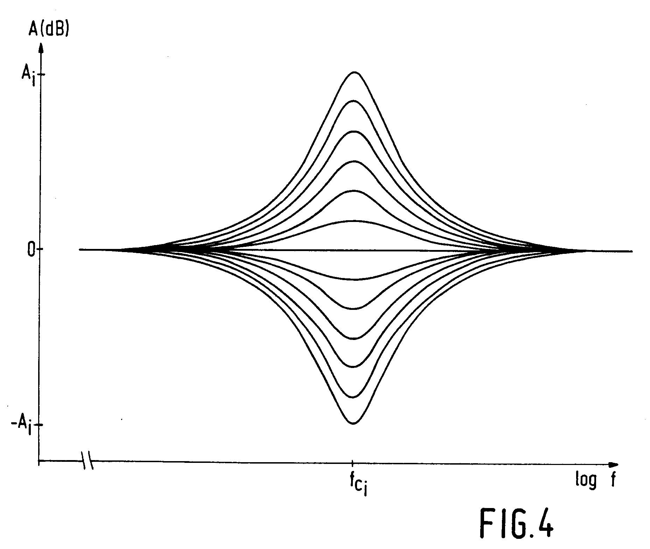

The book "Digital Signal Processing" by A.V. Oppenheim and R.W. Schafer, see page 170, Figure 4.33 discloses such a bandfilter.

The known filter comprises a coupled pole pair structure. This means that the two coefficients which correspond to the first and the second gain factor are equal. If their sign is ignored, the same applies to the two coefficients which correspond to the third and the fourth gain factor. The representation of the coefficients as a digital number for its supply to the filter in digital form implies that a rounding-off is generally effected because the digital number is always expressed in a limited number of bits. It is common practice to choose these digital numbers for the first and the second gain factor and for the third and the fourth gain factor to be equal as well. Using these digital numbers, the digital filter which is obtained will therefore only give an approximation of the desired filter characteristic.

The invention has for its object to propose a band filter that more correctly approximates the desired filter characteristic. To that end, the bandfilter according to the invention is characterized in that the difference between the two coefficients corresponding to a first gain factor representing the loop gain in the circuit from the output of the first signal combination unit via the first delay means and the associated feedback to the first signal combination unit and a second gain factor representing the loop gain in the circuit from the output of the second signal combination unit via the second delay means and the associated feedback to the second signal combination unit is equal the value of the least significant bit of these coefficients, and/or, if the sign of the relevant coefficients are ignored, the difference between the two coefficients corresponding to a third gain factor representing the gain in the circuit from the output of the first signal combination unit via the first delay means to the input of the the second signal combination unit and a fourth gain factor representing the gain in the circuit from the output of the second signal combination unit via the second delay means and the associated feedback to the input of the input of the first signal combination unit is equal to the value of the least significant bit of these coefficients.

In fact, the foregoing implies that the digital representation of two coefficients which are equal in the known filter now differ from each other by the value of the least significant bit.

In order to obtain the unequal coefficients the bandfilter can be further characterized in that if the calculated value for the two coefficients corresponding to the first and the second gain factor, and/or if the caluclated value for the two coefficients corresponding to the third and the fourth gain factor, (which value is equal for the first and the second gain factor, and is equal for the third and the fourth gain factor if their sign is ignored), is located in a partial region which itself is located entirely within a region of values bounded by the two digital numbers directly below and directly above the calculated value, then the one coefficient is equal to one digital number and the other coefficient is equal to the other digital number. It is apparent form the Figure shown in the above-mentioned publication that, if the sign is ingnored every time two of the four coefficients are equal to each other. Let it be assumed that the value $a_c$ is found for the coefficients corresponding to the first and the second gain factor, which value can be represented by means of a digital number having a limited number of bits only after rounding off. Let it be assumed that the calculated value $a_c$ for the coefficients lies between the digital number "n" and "n + 1" where n is an integer. The coeficients $a_1$ and $a_2$ for the two gain factors can now be determined, for example, from the following Table.

| | | $a_1$ | $a_2$ |
|---|---|---|---|
| 1. | $n \leq a_c < n + \Delta 1$ | n | n |
| 2. | $n + \Delta 1 \leq a_c \leq n + \Delta 2$ | n | n + 1 |
| 3. | $n + \Delta 2 < a_c \leq n + 1$ | n + 1 | n + 1 |

wherein $\Delta 1 < \Delta 2$, for example, $\Delta 1 = 0.25$ and $\Delta 2 = 075$. Since the circuit is symmetrical for $a_1$ and $a_2$, $a_1$ could also have been taken to be equal to n + 1 and $a_2$ could have been taken to be equal to n in the second case.

The invention will be described in greater detail with reference to the following description of the Figures:

Figure 1 is an embodiment of the filter,

Figure 2 shows the contents of a memory associated with the digital dilter having an adjustable central frequency,

Figure 3 shows in Figure 3a a number of filter characteristics of the digital filter of Figure 1 in which the filter coefficients are obtained in accordance with the known computing method and Figure 3b shows a number of filter characteristics with filter coefficients obtained in accordance with the new computing method,

Figure 4 shows a set of desired filter characteristics to be approximated by the bandfilter of Figure 1.

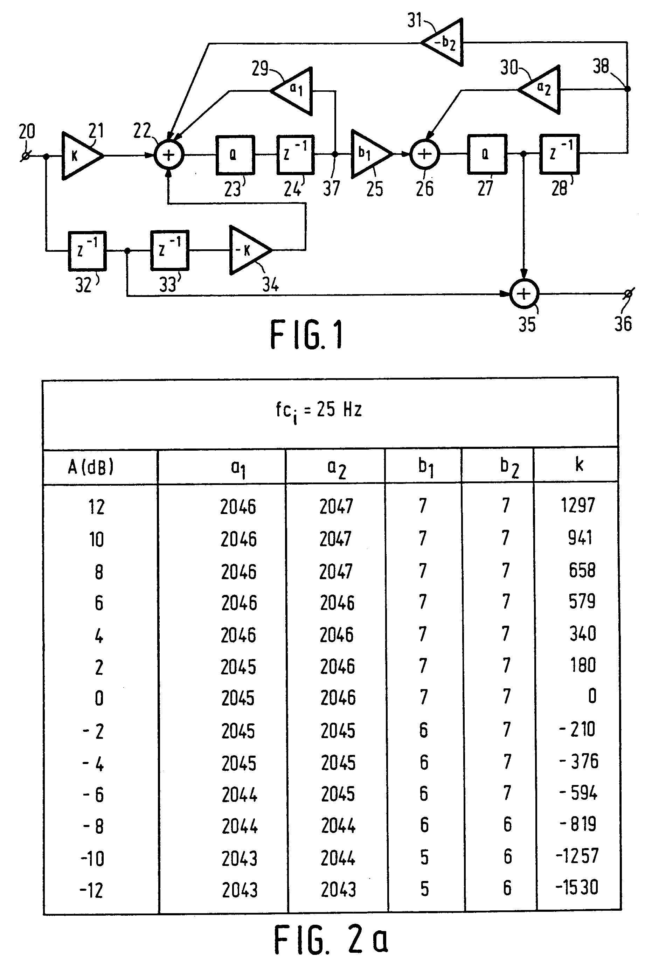

Figure 1 shows an embodiment of the filter. The input 20 is coupled via an amplifier stage 21 having a gain factor of k to an input of a signal combination unit 22. The output of the signal combination unit 22 is coupled to a series arrangement of a quantiser 23, a delay means 24 denoted by $z^{-1}$, an amplifier stage 25 having a gain factor of $b_1$, a second signal combination unit 26, a quantiser 27 and a second delay means 28. The outputs of the delay means 24 and 28 are fed back via amplifier stages 29 and 30 having gain factors of $a_1$ and $a_2$, respectively, to inputs of the first and second signal combination units 22 and 26, respectively. The output of the delay means 28 is also fed back via an amplifier stage 31 having a gain factor of $-b_2$ to an input of the signal combination unit 22. Furthermore, the input 20 is coupled via delay means 32 and 33 and an amplifier stage 34 having a gain factor of -k to an input of the signal combination unit 22. Finally, the output of the delay means 32 and the output of the quantiser 27 are coupled to the output 36 via a signal combination unit 35.

All delay means in the circuit have the same delay time. The elements 23 and 27 are quantisers which are commonly used in digital systems for reducing the data flow of digital numbers to the disered quantity of bits. When the quantisers reduce the numbers to, for example, 24 bits, digital numbers having a length of 36 bits will be presented to the signal combination unit 26 as a result of the multiplication in, for example, the amplifier stage 25 in which the gain factor $b_1$ is represented, for example, by a 12-bit number. The quantiser 27 now reduces these 36-bit numbeers to 24-bit digital numbers.

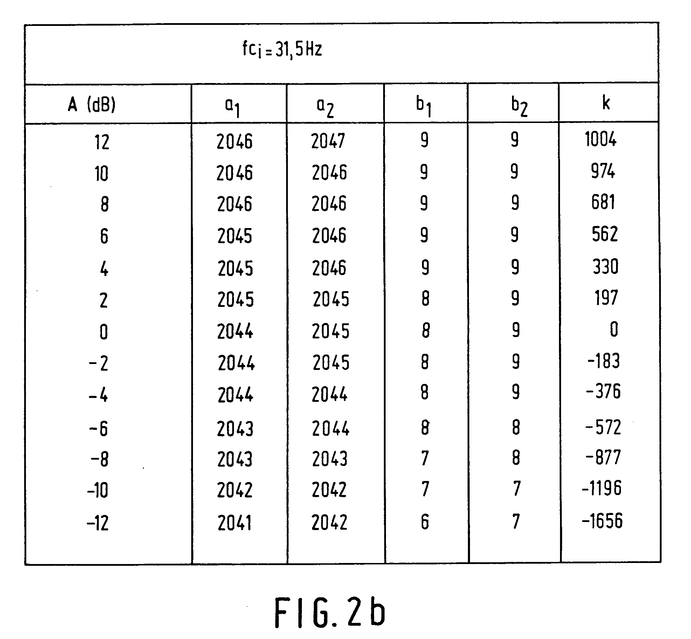

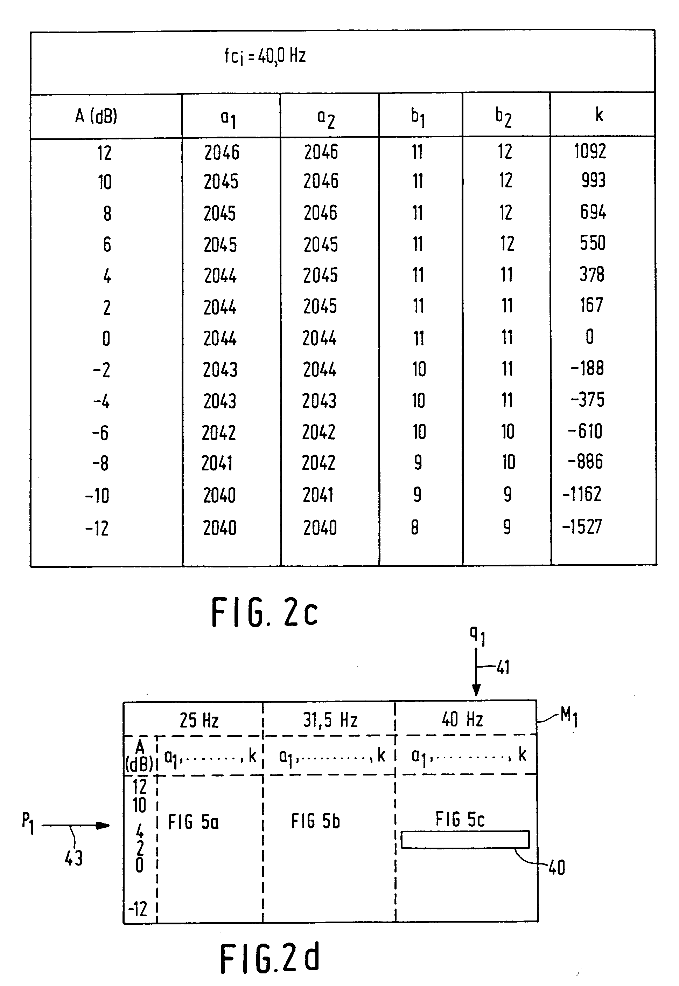

Figures 2, 2b and 2c show the values of the coefficients $a_1$, $a_2$, $b_1$, $b_2$ and k corresponding again to the gain factors of the amplifier stages 29, 30, 25, 31 and 21 and 34 (the latter two having the value k), respectively, more specifically for three central frequencies of 25 Hz, 31.5 Hz and 40 Hz and for different gains in the band. If the characteristic of the filter must be set at a central frequency of 40 Hz and a gain of 4 dB is to be realised in the band, then it is evident from Figure 2c that $a_1$ + 2044, $a_2$ = 2045, $b_1$ = 11 and k = 167. These coefficients are presented to the filter and they are stored in the filter so that the desired gain factors are set in the amplifier stages of the circuit of Figure 1.

Figure 2d diagrammatically shows a memory $M_1$ with three times thirteen sets of coeffficients. By means of a control signal (not shown), that part of the memory $M_1$ is selected which is associated with a given central frequency, i.e. the right-hand part in the aforedescribed example (see the arrow 41 which indicates that the control signal selects the part associated with 40 Hz), The control signal also selects the set of coefficients from the relevant part, which set is associated with a gain factor of 4 dB in accordance with the aforementioned example. This set of coefficients is diagrammatically denoted by means of the block 40. The arrow 43 indicates that the control signal selects the 4 dB gain.

The filter described in Figure 1 is known in the art. The coefficients $a_1$, $a_2$ can be calculated for a desired filter characteristic and are basically equal. The same applies to the coeffficients $b_1$, $b_2$. This is because the circuit is symmetrical for $a_1$ and $a_2$, and $b_1$ and $b_2$, respectively. When the coeffients are to be subsequently represented digitally, they can be rounded off in the normal manner so that the digital representations of the coefficients $a_1$ and $a_2$ and $b_1$, $b_2$, respectively, are equal again.

However, Figure 2 shows that in some cases $a_1$ and $a_2$ or $b_1$ and $b_2$ are not equal. The reason is that in these cases the filter characteristic thus obtained approximates the desired filter characteristic better than in the case when $a_1$ and $a_2$ are equal and when $b_1$ and $b_2$ are equal.

Three situations will be described hereinafter:

1. In the first situation a calculation has shown, for example, that the coefficients a are both 2045.2. This value is below 2045.25. In this case the value 2045 is taken for both $a_1$ and $a_2$ (see Figure 2a at the gain of -4 dB and -2 dB).

2. In a second situation the calculation has shown, for example, that the coefficients a are both 2045.8. This value is above 2045.75. In this case the value 2046 is taken for both $a_1$ and $a_2$ (see Figure 2a at the gain of +4 dB and +6 dB).

3. In a third situation the calculation has given, for example, the value 2045.6. This value is between 2045.25 and 2045.75. In this case $a_1$ is taken to be equal to 2045 and $a_2$ is 2046 (see Figure 2a at the gain of 0 and 2 dB).

Note. Instead, $a_1$ could have been taken to be 2046 and $a_2$ could have been taken to be 2045. At the gain of 2 dB in Figure 2a a different value for k would then have been obtained. The above described situations likewise apply to the coefficients $b_1$ and $b_2$.

The result is that the first two cases yield a band filter which is known in the art. In the last case a novel band filter is obtained realising a better approximation of the desired filter characteristic. The characteristic feature of this filter is that the coefficients $a_1$ and $a_2$ and/or the coefficients $b_1$ and $b_2$ differ from each other by the value of 1x the least significant bit.

Suppose that a set of filter characteristics need to be realised as is shown in Figure 4.

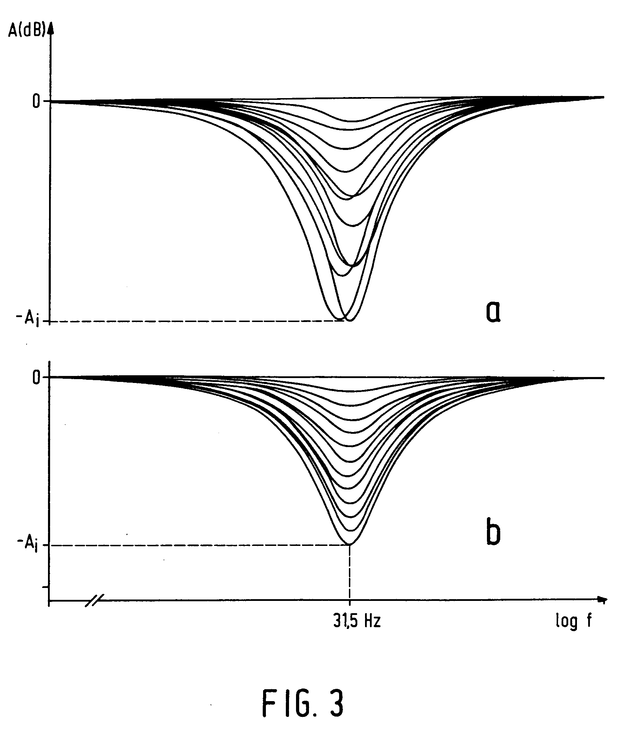

Figures 3a and b show the different filter characteristics obtained by means of the known calculation method (Figure 3a - the coefficients $a_1$ and $a_2$ are equal to each other and the coefficients $b_1$ and $b_2$ are equal to each other) and by means of the calculation method as described hereinbefore (Figure 3b in which for some sets of coefficients $a_1$, $a_2$, $b_1$, $b_2$ these coefficients $a_1$ and $a_2$ or $b_1$ and $b_2$ differ from each other by the least significant bit). This relates to the wish to realise filter characteristics at a central frequency of 31.5 Hz with a negative gain factors varying in steps of 1dB from 0 dB to ($-A_i$ =) -12 dB. The filters thus attenuate to a greater or lesser extent within the band. For the purpose of clarification the vertical axis in Figure 3a is slightly extended so that the variation of the characteristic curves in this figure is more clearly visible. It is clear that the filter characteristics of Figure 3b show a much greater resemblance to those of Figure 4 than do the filter characteristics of Figure 3a.

The amplifier stage 29 in the circuit of Figure 1 may be disposed in the circuit from the input of the signal combination unit 22 to the tapping point 37 for the feedback to the signal combination unit 22. If this is so, the gain factor $a_1$ still determines the gain in the circuit from the output of the first signal combination unit 22 via the delay means 24 and the associated feedback to the first signal combination unit 22. However, the gain factor for the amplifier stage 25 will then have to be changed to the value $\frac{b_1}{a_1}$, in order that the gain in the circuit from the output of the first signal combination unit 22 via the delay means 24 to the input of the second signal combination unit 26 remains equal to $b_1$. Another possibility is to dispose the amplifier stage 25 between the output of the signal combination unit 22 and the tapping point 37. In that case the gain factor of the amplifier stage 29 will have to be modified to $\frac{a_1}{b_1}$ in order that the gain factor from the output of the signal combination unit 22 via the delay means 24 and the associated feedback to the first signal combination unit 22 remains equal to $a_1$. Similar considerations apply to a displacement of the amplifier stage 30 or the amplifier stage 31 to within the circuit from the output of the signal combination unit 26 via the delay means 28 to the tapping point 38.

For a further discussion of the bandfilter of the invention is referred to European Patent Application 209,931, also in the name of the applicant of the present application, in which the use of the bandfilter in an equaliser is described.

**Claims**

1. A digital band filter having an input (20) coupled to a series arrangement of a first signal combination unit, (22) a first delay means, (24) a second signal combination unit (26) and a second delay means, (28) the outputs of the first (24) and second delay means (28) being coupled, via associated feedback paths, to an input of the first signal combination unit (22) and an input of the second signal combination unit (26) respectively, the output of the second delay means (28) being also fed back to an input of the first signal combination unit, (26) characterized in that the difference between the two coefficients corresponding to a first gain factor (a1) representing the loop gain in the circuit from the output of the first signal combination unit (22) via the first delay means (24) and the associated feedback to the first signal combination unit (26) and a second gain factor (a2) representing the loop gain in the circuit from the output of the second signal combination unit (26) via the second delay means (28) and the associated feedback to the second signal combination unit (26) is equal to the value of the least significant bit of these coefficients, and/or, if the sign of the relevant coefficients are ignored, the difference between the two coefficients corresponding to a third gain factor (b1) representing the gain in the circuit from the output of the first signal combination unit (22) via the first delay means (24) to the input of the the second signal combination unit (26) and a fourth gain factor (b2) representing the gain in the circuit from the output of the second signal combination unit (26) via the second delay means (28) and the associated feedback to the input of the input of the first signal combination unit (22) is equal to the value of the least significant bit of the coefficients.

2. A band filter as claimed in Claim 1, characterized in that the calculated value for the two coefficients corresponding to the first (a1) and the second gain factor, (a2) and/or the caluclated value for the two coefficients corresponding to the third and the fourth gain (b2) factor, is located in a partial region which itself is located entirely within a region of values bounded by the two digital numbers directly below and directly above the calculated value, the one coefficient being equal to one digital number and the other coefficient being equal to the other digital number.

**Patentansprüche**

1. Digitales Bandfilter mit einem mit einer Reihenschaltung aus einer ersten Signalkombinationseinheit (22), einem ersten Verzögerungsmittel (24), einer zweiten Signalkombinationseinheit (26) und einem Zweiten Verzögerungsmittel (28) gekoppelten Eingang (20), wobei der Ausgang des ersten (24) bzw. des zweiten (28) Verzögerungsmittels über zugehörige Rückkopplungspfade mit einem Eingang der ersten Signalkombinationseinheit (22) bzw. einem Eingang der zweiten Signalkombinationseinheit (26) gekoppelt ist, und der Ausgang des zweiten Verzögerungsmittels (28) ebenfalls auf einen Eingang der ersten Signalkombinationseinheit (22) zurückgekoppelt ist, dadurch gekennzeichnet, daß der Unterschied zwischen den beiden Koeffizienten entsprechend einem ersten Verstärkungsfaktor (a1), der die Schleifenverstärkung in der Schaltung vom Ausgang der ersten Signalkombinationseinheit (22) über das erste Verzögerungsmittel (24) und die zugehörige Rückkopplung zur ersten Signalkombinationseinheit (22) darstellt, und entsprechend einem zweiten Verstärkungsfaktor (a2), der die Schleifenverstärkung in der Schaltung vom Ausgang der zweiten Signalkombinationseinheit (26) über das zweite Verzögerungsmittel (28) und die zugehörige Rückkopplung zur zweiten Signalkombinationseinheit (26) darstellt, gleich dem Wert des niedrigstwertigen Bits dieser Koeffizienten ist, und/oder, wenn das Vorzeichen der betreffenden Koeffizienten vernachlässigt wird, der Unterschied zwischen den beiden Koeffizienten entsprechend einem dritten Verstärkungsfaktor (b1), der die Verstärkung in der Schaltung vom Ausgang der ersten Signalkombinationseinheit (22) über das erste Verzögerungsmittel (24) zum Eingang der zweiten Signalkombinationseinheit (26) darstellt, und entsprechend einem vierten Verstärkungsfaktor (b2), der die Verstärkung in der Schaltung vom Ausgang der zweiten Signalkombinationseinheit (26) über das zweite Verzögerungsmittel (28) und die zugehörige Rückkopplung zum Eingang der ersten Signalkombinationseinheit (22) darstellt, gleich dem Wert des niedrigstwertigen Bits der Koeffizienten ist.

2. Bandfilter nach Anspruch 1, dadurch gekennzeichnet, daß der berechnete Wert für die beiden dem ersten (a1) und dem zweiten Verstärkungsfaktor (a2) entsprechenden Koeffizienten, und/oder der berechnete Wert für die beiden dem dritten (b1) und dem vierten Verstärkungsfaktor (b2) entsprechenden Koeffizienten in einem Teilbereich liegt, der selbst vollständig innerhalb eines von den beiden Digitalzahlen unmittelbar unter und über dem berechneten Wert begrenzten Wertebereiches liegt, wobei der eine Koeffizient gleich der einen Digitalzahl und der andere Koeffizient gleich der anderen Digitalzahl ist.

**Revendications**

1. Filtre de bande numérique ayant une entrée (20) couplée à un montage série d'une première unité de combinaison de signaux (22), de premiers moyens à retard (24), d'une seconde unité de combinaison de signaux (26) et de seconds (28) moyens à retard, les sorties des premiers (24) et seconds moyens à retard (28) étant couplées à travers des trajets de réaction associés respectivement à une entrée de la première unité de combinaison de signaux (22) et à une entrée de la seconde unité de combinaison de signaux (26), la sortie des seconds moyens à retard (28) étant également rétrocouplée à une entrée de la première unité de combinaison de signaux (26), caractérisé en ce que la différence entre les deux coefficients correspondant, l'un, à un premier facteur d'amplification (a1) représentant le gain de boucle dans le circuit qui, à partir de la sortie de la première unité de combinaison de signaux (22), conduit, à travers les premiers moyens à retard (24) et la réaction associée, à la première unité de combinaison de signaux (26) et, l'autre, à un deuxième facteur de gain (a2) représentant le gain de boucle dans le circuit qui, à partir de la sortie de la seconde unité de combinaison de signaux (26), conduit, à travers les seconds moyens à retard (28) et la réaction associée, à la seconde unité de combinaison de signaux (26), est égale à la valeur du bit de poids le plus faible de ces coefficients et/ou, mis à part le signe des coefficients concernés, la différence entre les deux coefficients correspondant, l'un, à un troisième facteur d'amplification (b1) représentant le gain dans le circuit qui, à partir de la sortie de la première unité de combinaison de signaux (22) conduit, à travers les premiers moyens à retard (24), à l'entrée de la seconde unité de combinaison de signaux (26) et, l'autre, à un quatrième facteur d'amplification (b2) représentant le gain dans le circuit qui, à partir de la sortie de la seconde unité de combinaison de signaux (26), conduit, à travers les deuxièmes moyens à retard (28) et la réaction associée, à l'entrée de la première unité de combinaison de signaux (22), est égale à la valeur du bit de poids le plus faible de ces coefficients.

2. Filtre de bande selon la revendication 1, caractérisé en ce que la valeur calculée pour les deux coefficients correspondant aux premier (a1) et deuxième (a1) facteurs d'amplification et/ou la valeur calculée pour les deux coefficients correspondant aux troisième (b1) et quatrième (b2) facteurs d'amplification se situent dans un domaine partiel qui, lui-même, est entièrement compris dans un domaine de valeurs limité par les deux nombres numériques situés immédiatement au-dessous et au-dessus de la valeur calculée, l'un des coefficients étant égal à l'un des nombres numériques et l'autre coefficient étant égal à l'autre nombre numérique.

FIG.1

| fc_i = 25 Hz | | | | | |
|---|---|---|---|---|---|
| A (dB) | $a_1$ | $a_2$ | $b_1$ | $b_2$ | k |
| 12 | 2046 | 2047 | 7 | 7 | 1297 |
| 10 | 2046 | 2047 | 7 | 7 | 941 |
| 8 | 2046 | 2047 | 7 | 7 | 658 |
| 6 | 2046 | 2046 | 7 | 7 | 579 |
| 4 | 2046 | 2046 | 7 | 7 | 340 |
| 2 | 2045 | 2046 | 7 | 7 | 180 |
| 0 | 2045 | 2046 | 7 | 7 | 0 |
| - 2 | 2045 | 2045 | 6 | 7 | - 210 |
| - 4 | 2045 | 2045 | 6 | 7 | - 376 |
| - 6 | 2044 | 2045 | 6 | 7 | - 594 |
| - 8 | 2044 | 2044 | 6 | 6 | - 819 |
| -10 | 2043 | 2044 | 5 | 6 | -1257 |
| -12 | 2043 | 2043 | 5 | 6 | -1530 |

FIG. 2 a

| $fc_i = 31,5 Hz$ | | | | | |
|---|---|---|---|---|---|
| A (dB) | $a_1$ | $a_2$ | $b_1$ | $b_2$ | k |
| 12 | 2046 | 2047 | 9 | 9 | 1004 |
| 10 | 2046 | 2046 | 9 | 9 | 974 |
| 8 | 2046 | 2046 | 9 | 9 | 681 |
| 6 | 2045 | 2046 | 9 | 9 | 562 |
| 4 | 2045 | 2046 | 9 | 9 | 330 |
| 2 | 2045 | 2045 | 8 | 9 | 197 |
| 0 | 2044 | 2045 | 8 | 9 | 0 |
| -2 | 2044 | 2045 | 8 | 9 | -183 |
| -4 | 2044 | 2044 | 8 | 9 | -376 |
| -6 | 2043 | 2044 | 8 | 8 | -572 |
| -8 | 2043 | 2043 | 7 | 8 | -877 |
| -10 | 2042 | 2042 | 7 | 7 | -1196 |
| -12 | 2041 | 2042 | 6 | 7 | -1656 |

# FIG. 2b

| fc$_j$ = 40,0 Hz | | | | | |
|---|---|---|---|---|---|
| A (dB) | a$_1$ | a$_2$ | b$_1$ | b$_2$ | k |
| 12 | 2046 | 2046 | 11 | 12 | 1092 |
| 10 | 2045 | 2046 | 11 | 12 | 993 |
| 8 | 2045 | 2046 | 11 | 12 | 694 |
| 6 | 2045 | 2045 | 11 | 12 | 550 |
| 4 | 2044 | 2045 | 11 | 11 | 378 |
| 2 | 2044 | 2045 | 11 | 11 | 167 |
| 0 | 2044 | 2044 | 11 | 11 | 0 |
| -2 | 2043 | 2044 | 10 | 11 | -188 |
| -4 | 2043 | 2043 | 10 | 11 | -375 |
| -6 | 2042 | 2042 | 10 | 10 | -610 |
| -8 | 2041 | 2042 | 9 | 10 | -886 |
| -10 | 2040 | 2041 | 9 | 9 | -1162 |
| -12 | 2040 | 2040 | 8 | 9 | -1527 |

## FIG. 2c

FIG. 2d

FIG. 3

FIG.4